Europäisches Patentamt

(19) European Patent Office

Office européen des brevets

(11) Publication number: **0 059 835**
**A1**

(12) # EUROPEAN PATENT APPLICATION

(21) Application number: **82100647.5**

(22) Date of filing: **29.01.82**

(51) Int. Cl.³: **B 65 G 51/02**

(30) Priority: **05.03.81 US 240705**

(43) Date of publication of application:
**15.09.82 Bulletin 82/37**

(84) Designated Contracting States:
**CH DE FR GB IT LI NL**

(71) Applicant: **THE PERKIN-ELMER CORPORATION**
**Main Avenue**
**Norwalk Connecticut 06856(US)**

(72) Inventor: **Kohman, Wayne E.**
**38 Bald Hill Road**
**Wilton Connecticut 06897(US)**

(74) Representative: **Patentanwälte Grünecker, Dr.**
**Kinkeldey, Dr. Stockmair, Dr. Schumann, Jakob, Dr.**
**Bezold, Meister, Hilgers, Dr. Meyer-Plath**
**Maximilianstrasse 43**
**D-8000 München 22(DE)**

(54) **Laterally stable air track.**

(57) A laterally stable air track (17) for transporting silicon wafers (26) between work stations. Lateral stability of the transported wafer (16) is provided by the use of lateral air jets (22, 23) impinging on opposite edges of the wafers (26) to maintain the wafers centred of the air track (17) thus eliminating damaging mechanical contact of the wafers with the air track or guard rails.

FIG.4

EP 0 059 835 A1

Croydon Printing Company Ltd.

## BACKGROUND OF THE INVENTION

In the transport of thin fragile elements avoidance of damaging mechanical contact is important. Particularly is this true in the case of silicon wafers in process of being fabricated into integrated circuit chips. Mechanical contact of the wafer edges may remove a sizable portion of available area on which circuits may be formed. In addition, some mechanical contact may be forceful enough to completely destroy the wafer.

Various wafer transport systems have been devised for moving wafers between processing work stations. One such system employs conveyer belts or the like. This system has the inherent disadvantage of mechanical contact throughout wafer travel. While affording good lateral stability the mechanical contact and wear creates particles of photoresist which creates difficulties in further processing of the wafer.

Another method of transport utilizes an air track which comprises a flat surface with rows of orifices formed therein. Each orifice is angled in the longitudinal direction in which the wafer is to be transported which provides a vertical force vector to provide lift and a horizontal force vector to provide longitudinal movement. If the surface of the air track is perfectly flat, such an arrangement provides a minimum of lateral stability. However, this lateral stability is easily overcome when the wafer moves off center a very small amount. If the surface is off level even by an indiscernable amount, even the minimal lateral stability is lost. In such a system damage may occur by edge contact of the wafer with the surface of the air track or with guard rails which are often provided. Such contact may cause chips of the photoresist to break off and lodge on top of the wafer providing difficulties in further processing.

To overcome this problem some systems provide air jets located within the diameter of the wafer which have a radial vector. However, these systems usually require several rows of orifices arranged in complicated patterns to obtain lateral stability.

## BRIEF SUMMARY OF THE INVENTION

The present invention provides an air track arrangement for transporting silicon wafers between work stations wherein mechanical contact of the silicon wafer with the surface of the air track or a guard rail is eliminated by providing air jets which impinge on opposite edges of the wafers.

The present invention comtemplates an air track having one or more pairs of rows of orifices oriented at an angle to provide lift and movement of the wafer in the desired direction. In addition, two additional rows are located on either side of the transporting rows of orifices. The orifices in these rows are at an angle with the horizontal and at a distance from each such that air jets emitting therefrom impinge on the edges maintaining the wafer as it travels in the longitudinal direction centered. In the event of deviation of the wafer from the center of the air track the air jets from one outer ᵥrow of orifices passes over the wafer providing no force. The other edge of the wafer, however, passes over the other outer row of orifices from which the air jets impinge on the bottom surface of the wafer providing a force to quickly move the wafer to the center of the air track. Due to momentum of the wafer, it may move from side-to-side with diminishing distances until it is stably centered where it is again maintained by the impinging air jets.

## DESCRIPTION OF THE DRAWINGS

Fig. 1 is an illustration useful in explaining the lateral instability problem associted with prior art air track wafer transportion systems;

Fig. 2 is a geometrical illustration also useful in explaining lateral instability problem of a prior art air track;

Fig. 3 is a top view of the air track of the present invention;

Fig. 4 is a schematic illustration useful in explaining the present invention.

## DESCRIPTION

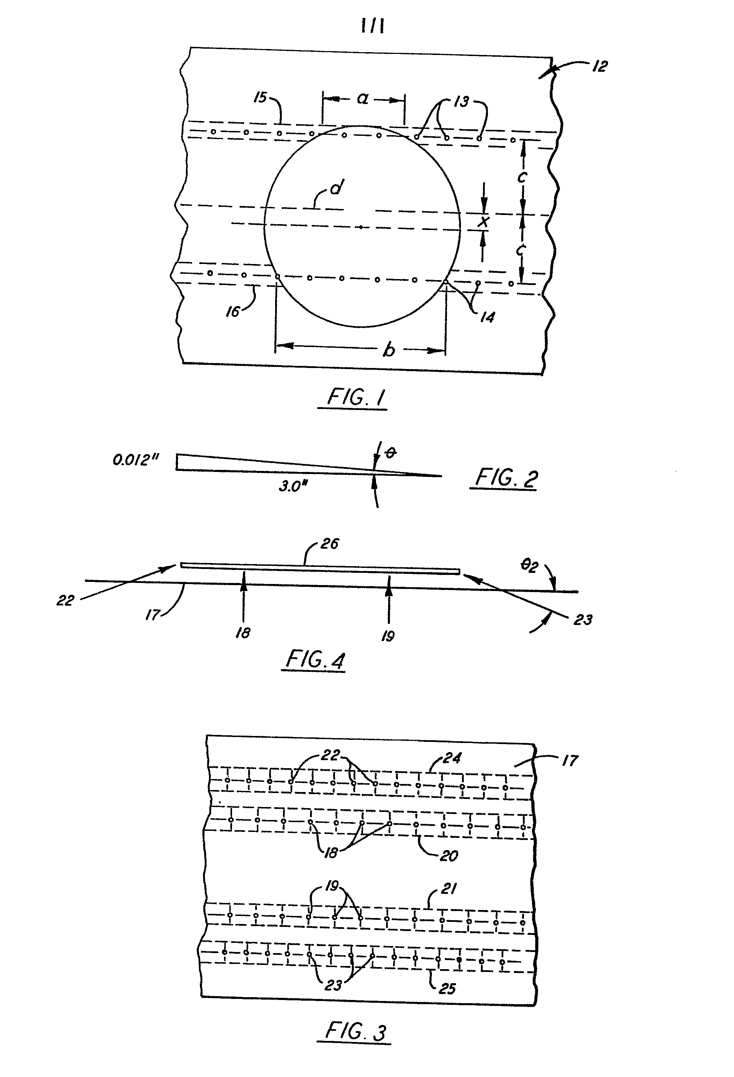

Fig. 1 shows a wafer 11 off center on a length air track 12 by $\alpha$ amount. Two lines of orifices 13 and 14 are shown. Each orifice is designed so that air jets using therefrom make an acute angle with the horizontal such that the wafer is lifted and propelled in a longitudinal direction, e.g., from right to left. The lines of orifice 13 and 14 communicate via conduits 15 and 16, respectively, with a supply of pressurized air (not shown).

The lines of orifices 13 and 14 are equidistant, i.e., each is at a distance c from the centerline d of the air track 12.

When the wafer 11 is off center of the air track, e.g., by the distance $\alpha$ , it covers more orifices 14 on one side and less orifices 13 on the air track. It has been found that the lifting force developed by each line of orifices 13 and 14 is proportional to the dimension a or b covered by the wafer 11 and that the unbalance in lifting forces a and b is a function of orifice line separation 2c and wafer lateral offset $\alpha$.

Lateral forces on the wafer are a function of the angle of tilt of the wafer 11. This is so since the vector lift force on the wafer 11 is perpendicular to the flat bottom of the wafer. Such forces have the tendency to move the wafer 11 back to the center of the air track. However, the tilt angle is limited by the maximum floating height of the wafer on the high side which is approximately 0.012 in. for a three inch diameter wafer with the height on the low side being zero.

Thus, referring to Fig. 2 it can be seen that maximum tilt angle is:

$$\tan\theta = \frac{0.012}{3.0} = 0.004$$

$$\theta = 0.23 \text{ degrees}$$

where $\theta$ is the tilt angle

While the lateral forces developed could keep the wafer 11 centered, the low force provided could be overpowered by a tilt of 0.3 degrees of the air track 12.

Thus, it can be seen that mechanical contact of the low side of the wafer 11 with the surface of the air track 12 frequently occurs at the low side of the wafer. This contact may cause the wafer 11 to pivot back to the center of the track but the damaging effect on the wafer 11 caused by the mechanical contact is unacceptable.

Thus, centering of the wafer 11 of Fig. 1 can occur only if the tilt angle is less than 0.3 degrees which is virtually impossible to maintain since maintaining of air track 12 to meet this criteria is virtually impossible.

Use of orifices located under the wafer providing air jets with a radial vector have been found useful to alleviate this problem. However, these generally involve many rows of orifices arranged in complicated patterns and are therefore, costly and difficult to manufacture.

Fig. 3 illustrates the air track 17 having inner lines of orifices 18 and 19. The orifices 18 and 19 communicate, respectively, with conduits 20 and 21. These conduits are connected to a source of pressurized air (not shown). The orifices are designed such that air jets emitted therefrom form an acute angle with the horizontal (the plane of the drawing) such that they provide a lift vector and a vector for propelling a wafer in the longitudinal direction, e.g., right to left.

Two outer lines of orifices 22 and 23 communicate with conduits 24 and 25 which are connected to the source of pressurized air (not shown). The orifices 22 and 23 are designed so that air jets emitted therefrom are in the radial direction and at an acute angle with the horizontal. The distance separating the lines of orifices 22 and 23 depends on the diameter of the wafer to be transported. Their distance and angle should be such that each air jet emitting therefrom impinges on an edge of a perfectly centered wafer. This arrangement acts as a restraining force to maintain the wafers centered during its longitudinal travel.

This is best seen in Fig. 4 where a wafer 26 is shown with the jets from orifices 22 and 23 impinging on the edges of the centered wafer 26. It has been found that the present invention works well when the angle of the jets is approximately $\theta$ =20°.

As can be seen the jets from orifices impinge approximately at the edge of a centered wafer 27 and therefore cancel one another. However, if wafer 27 moves from center, e.g., to the right, jets from orifices 22 pass over the top of wafer 27 and produce no lateral force thereon. The jets from orifices 23, however, produce a lateral force on the bottom of the wafer 27 causing the wafer to return to a centered position. In addition, the vertical vector of the jets from orifices 23 keeps the edge of the wafer from making mechanical contact with the surface of the air track 17.

Of course if the wafer 27 moves to the left orifices 22 cause it to be recentered in the same manner.

The air track 17 of the present invention is adaptable for use with wafers of any diameter simply by changing distances between lines of orifices 18 and 19 and 22 and 23.

Other modifications of the present invention are possible in light of the above description which should not be construed as placing limitations on the present invention beyond those expressly set forth in the claims which follow:

## WHAT IS CLAIMED IS:

1. An apparatus for transporting an object between work stations, comprising in combination,

a track comprising a flat surface,

first means providing air jets to lift and propel the object in a longitudinal direction,

second means providing air jets impinging on opposite sides of the object to maintain the object centered on said track as it moves in a longitudinal direction.

2. An apparatus according to claim 1 wherein the object is a thin circular wafer.

3. An apparatus according to claim 2 wherein said first means comprises,

first and second rows of orifices disposed on each side of the centerline of said track at a distance from each other less than the diameter of the wafer,

said orifices forming an acute angle with the horizontal in the longitudinal direction of said track.

4. An apparatus according to claim 3 wherein said second means comprises,

third and fourth rows of orifices disposed on each side of the centerline of said track at a distance from each other slightly greater than the diameter of the wafer,

said orifices forming an acute angle with the horizontal in the axial direction of said track such that air jets issuing therefrom impinge on the edges of the wafer.

5. An apparatus according to claim 4 further including,

conduit means communicating with said first, second, third and fourth rows of orifices for connecting a source of pressurized air to said conduits means whereby said first and second rows of orifices provide air jets to lift and propel the wafer in said longitudinal direction and said third and fourth rows of orifices provide air jets to maintain the wafer centered or recenter the wafer if it deviates from the centerline of said track.

1/1

*FIG. 1*

*FIG. 2*

*FIG. 4*

*FIG. 3*

## European Patent Office

## EUROPEAN SEARCH REPORT

EP 82100647.5

| | DOCUMENTS CONSIDERED TO BE RELEVANT | | CLASSIFICATION OF THE APPLICATION (Int. Cl. ³) |
|---|---|---|---|
| Category | Citation of document with indication, where appropriate, of relevant passages | Relevant to claim | |
| A | FR - A - 2 348 130 (MONSERIE) <br> * Page 9, lines 6-15; fig. 7,8 * <br> -- | 1,3,4, 5 | B 65 G 51/02 |
| A | DE - B - 1 263 608 (SPENCER) <br> * Column 12, lines 12-17; fig. 2,4 * <br> -- | 1,3,4, 5 | |
| A | US - A - 4 081 201 (HASSAN) <br> ---- | 1 | |

**TECHNICAL FIELDS SEARCHED (Int.Cl. ³)**

B 65 G 51/00

B 65 G 53/00

H 01 L 21/00

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

| X | The present search report has been drawn up for all claims | | |
|---|---|---|---|
| Place of search | Date of completion of the search | Examiner | |
| VIENNA | 03-06-1982 | PISSENBERGER | |

EPO Form 1503.1  06.78